# EUROPEAN PATENT APPLICATION

(11) **EP 4 247 135 A1**
(43) Date of publication of application: **20.09.2023**
(21) Application number: 21891953.8
(22) Date of filing: 11.11.2021
(51) Int. Cl.: H05K 9/00

(54) **ELECTROMAGNETIC WAVE SHIELDING BODY**

(30) Priority: 13.11.2020 JP 2020189668
(71) Applicant: AGC INC., Chiyoda-ku, Tokyo 1008405 (JP)
(72) Inventor: TANAKA Tsuyoshi, Tokyo 100-8405 (JP); INOUE Seiji, Tokyo 100-8405 (JP); KAWAKAMI Remi, Tokyo 100-8405 (JP)
(74) Representative: Müller-Boré & Partner Patentanwälte PartG mbB
(86) International application number: PCT/JP2021/041527
(87) International publication number: WO 2022/102708

(57) **Abstract**

To provide a technique to realize a reduction in the laminating temperature, improvement of bubble release properties of the resin layer, improvement of workability in laminating operation, and suppression of a change of appearance after lamination.

The electromagnetic wave shielding body is a laminate which shields electromagnetic waves. The electromagnetic wave shielding body has a first dielectric layer, a second dielectric layer, a resin layer to bond the first dielectric layer and the second dielectric layer, and a metal woven wire mesh disposed in the resin layer. The resin layer contains a thermoplastic ethylene/vinyl acetate (EVA) resin or a thermoplastic resin containing a block copolymer hydride having some of unsaturated bonds of a block copolymer hydrogenated. The thermoplastic EVA resin contains no organic peroxide nor silane coupling agent. The elastic modulus in tension at 100°C of the resin layer is less than 5.0×10⁵ Pa.

## Description

### TECHNICAL FIELD

The present disclosure relates to an electromagnetic wave shielding body.

### BACKGROUND ART

The electromagnetic wave shielding material as disclosed in Patent Document 1 has a transparent substrate, an adhesive layer and a metal mesh sheet. The adhesive layer contains a curable resin. The metal mesh sheet is one having a large number of holes formed on a metal foil by photoresist and etching or by punching.

The glass resin laminate as disclosed in Patent Document 2 has at least two glass plates, a silicone resin layer disposed between the two glass plates and bonding the principal surfaces of the two glass plates, and a metal layer disposed in the silicone resin layer. The metal layer is in a mesh form.

### PRIOR ART DOCUMENTS

### PATENT DOCUMENTS

Patent Document 1: JP-A-2004-72010
Patent Document 2: JP-A-2020-128314

### DISCLOSURE OF INVENTION

### TECHNICAL PROBLEM

In Patent Document 1, first, a transparent substrate, an adhesive film, a metal mesh sheet, an adhesive film and a transparent substrate are laminated in this order to prepare a laminate. Then, the laminate is placed in a vacuum bag, and in a state where the vacuum bag is evacuated of air, the vacuum bag is heated to 85°C. The laminate is taken out from the vacuum bag and heated to 130°C to cure the adhesive sheet. This method has a problem of an increase of the production cost due to lamination at high temperature of about 130°C.

In Patent Document 2, a silicone resin is sandwiched between two glass plates. A silicone resin has high fluidity even at room temperature and has favorable bubble release properties. However, the silicone resin, when sandwiched between the two glass plates, may flow out from between the two glass plates, thus impairing workability. Further, a silicone resin has high water absorption, and a change of appearance is likely to occur after lamination. The change of appearance may occur also by heat cycles.

The problem of the change of appearance may occur also in e.g. a polyvinyl butyral (PBV) resin. Further, the PVB resin is problematic also in that it has low flowability at low temperature of about 100°C and bubble release properties are poor at the time of lamination.

According to an embodiment of the present disclosure, provided is a technique to realize a reduction in the laminating temperature, improvement of the bubble release properties of the resin layer, improvement of workability in laminating operation, and suppress of the change of appearance after lamination.

### SOLUTION TO PROBLEM

The electromagnetic wave shielding body according to an embodiment of the present disclosure is a laminate to shield electromagnetic waves. The electromagnetic wave shielding body has a first dielectric layer, a second dielectric layer, a resin layer to bond the first dielectric layer and the second dielectric layer, and a metal woven wire mesh disposed in the resin layer. The metal woven wire mesh has apertures formed by metal wires intersecting with one another. The resin layer contains a thermoplastic ethylene/vinyl acetate (EVA) resin or a thermoplastic resin containing a block copolymer hydride having some of unsaturated bonds of a block copolymer hydrogenated. The thermoplastic EVA resin contains no organic peroxide nor silane coupling agent. The elastic modulus in tension at 100°C of the resin layer is less than 5.0×10⁵ Pa.

The electromagnetic wave shielding body according to an embodiment of the present disclosure is a laminate to shield electromagnetic waves. The electromagnetic wave shielding body has a first dielectric layer, a second dielectric layer, a resin layer to bond the first dielectric layer and the second dielectric layer, and a metal woven wire mesh disposed in the resin layer. The metal woven wire mesh has apertures formed by metal wires intersecting with one another. The resin layer has a coefficient of water absorption of less than 0.1% measured in accordance with ASTM D570 (Standard test method for water absorption of plastics), has an elastic modulus in tension at 25°C of 10 kPa or more, and has an elastic modulus in tension at 100°C of less than 5.0×10⁵ Pa.

### ADVANTAGEOUS EFFECTS OF INVENTION

According to an embodiment of the present disclosure, even when a metal woven wire mesh having steps is disposed in the resin layer of the electromagnetic wave shielding body, by using an EVA resin or a resin containing a block copolymer hydride, having an elastic modulus in tension at 100°C of less than 5.0×10⁵ Pa, for the resin layer, a reduction in the laminating temperature, improvement of bubble release properties of the resin layer, improvement of workability in laminating operation, and suppression of the change of appearance after lamination, can be realized.

According to an embodiment of the present disclosure, even when a metal woven wire mesh having steps is disposed in the resin layer of the electromagnetic wave shielding body, by using a resin layer having a coefficient of water absorption of less than 0.1%, an elastic modulus in tension at 25°C of 10 kPa or more, and an elastic modulus in tension at 100°C of less than 5.0×10⁵ Pa, a reduction in the laminating temperature, improvement of bubble release properties of the resin layer, improvement of workability in laminating operation, and suppression of the change of appearance after lamination, can be realized.

### BRIEF DESCRIPTION OF DRAWINGS

Fig. 1 is a cross sectional view illustrating an electromagnetic wave shielding body according to an embodiment.
Fig. 2 is a plan view illustrating an example of a metal woven wire mesh.
Fig. 3 is a cross sectional view illustrating an electromagnetic wave shielding body according to a first modified example.
Fig. 4 is a plan view illustrating an example of a slit pattern of a conductive layer.
Fig. 5 is a cross sectional view illustrating an electromagnetic wave shielding body according to a second modified example.

### DESCRIPTION OF EMBODIMENTS

In the following, embodiments of the present disclosure will be described with reference to drawings. In the drawings, the same or corresponding structures are represented by the same reference symbols, and explanation may sometimes be omitted. In this specification, " to " used to show the range of the numerical values is used to include the numerical values before and after it as the lower limit value and the upper limit value.

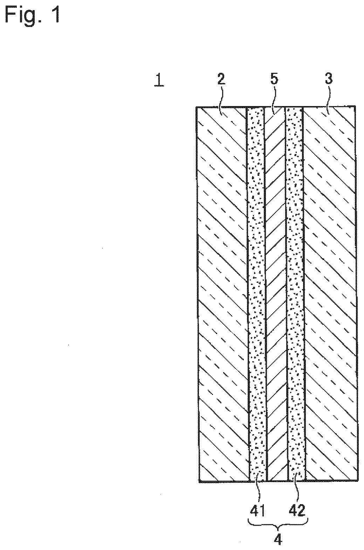

First, an electromagnetic wave shielding body 1 according to the present embodiment will be described with reference to Fig. 1. The electromagnetic wave shielding body 1 is a laminate for shielding electromagnetic waves. The electromagnetic wave shielding body 1 reflects electromagnetic waves. As described later, the electromagnetic wave shielding body 1 not only reflets electromagnetic waves but may absorb electromagnetic waves. In a case where the frequency of electromagnetic waves is from 100 MHz to 1 GHz, the electromagnetic wave shielding ratio is preferably 40 dB or more. In the above frequency band, the electromagnetic wave shielding ratio is more preferably 50 dB or more, further preferably 60 dB or more. Further, in the above frequency band, the electromagnetic wave shielding ratio is preferably 100 dB or lower. The electromagnetic wave shielding ratio is measured by KEC method (method of measuring electromagnetic wave shielding effect developed by KEC Kansai Electronic Industry Development Center).

The electromagnetic wave shielding body 1 is preferably a laminate having a visible light transmittance of 30% or more. When the visible light transmittance is 30% or more, the user can see e.g. the scenery through the electromagnetic wave shielding body 1. The application of the electromagnetic wave shielding body 1 is, for example, a window glass of a building, a vehicle or the like. The visible light transmittance is more preferably 40% or more, further preferably 50% or more, particularly preferably 60% or more. Further, the visible light transmittance is preferably 90% or less. The visible light transmittance is measured in accordance with Japanese Industrial Standards JIS R3106:1998 and is calculated in accordance with the formula for a case where standard illuminant D65 is used.

The electromagnetic wave shielding body 1 has a first dielectric layer 2, a second dielectric layer 3, and a resin layer 4 to bond the first dielectric layer 2 and the second dielectric layer 3. Further, the electromagnetic wave shielding body 1 further has a metal woven wire mesh 5 disposed in the resin layer 4. The resin layer 4 has for example a first adhesive layer 41 and a second adhesive layer 42. The metal woven wire mesh 5 is disposed between the first adhesive layer 41 and the second adhesive layer 42. The metal woven wire mesh 5 reflects electromagnetic waves.

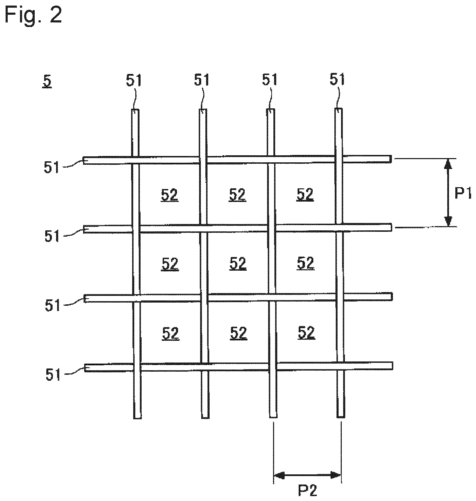

A method for producing the electromagnetic wave shielding body 1 will be briefly described. First, the first dielectric layer 2, the first adhesive layer 41, the metal woven wire mesh 5, the second adhesive layer 42 and the second dielectric layer 3 are overlaid in this order to prepare a laminate. The laminate is placed in a vacuum bag, and in a state where the vacuum bag is evacuated of air, the vacuum bag is baked in the air. The baking temperature is about 85°C. The laminate is taken out from the vacuum bag and heated while pressurized in an autoclave. The heating temperature is about 100°C. As a result, the first adhesive layer 41 and the second adhesive layer 42 enter into apertures 52 of the metal woven wire mesh 5 (see Fig. 2) and integrated to form the electromagnetic wave shielding body 1.

The resin layer 4 according to the present embodiment has the first adhesive layer 41 the second adhesive layer 42 integrated as sandwiching the metal woven wire mesh 5, but the technique in the present disclosure is not limited thereto. Only one of the first adhesive layer 41 and the second adhesive layer 42 may be used. Now, the respective layers constituting the electromagnetic wave shielding body 1 will be described.

Th first dielectric layer 2 may be disposed on the interior side or may be disposed on the exterior side based on the second dielectric layer 3. The material of the first dielectric layer 2 is glass, a ceramic or a resin. From the viewpoint of weight saving, the material of the first dielectric layer 2 is preferably a resin. As specific examples of the resin, a polyethylene terephthalate (PET) resin, a polycarbonate (PC) resin and an acrylic resin may be mentioned. On the other hand, from the viewpoint of scratch resistance, the material of the first dielectric layer 2 is preferably glass or a ceramic.

In a case where the first dielectric layer 2 is a glass plate, the glass plate is produced for example by float process or fusion process. The glass plate may be constituted by soda lime glass, alkali-free borosilicate glass, borosilicate glass, high silica glass or oxide glass composed of silicon oxide as the main component.

In a case where the first dielectric layer 2 is a glass plate or a ceramic plate, its thickness is for example from 0.1 mm to 10 mm, preferably from 1.0 mm to 10 mm, more preferably from 1.0 mm to 5.0 mm, further preferably from 1.8 mm to 4.0 mm, particularly preferably from 1.8 mm to 3.0 mm. On the other hand, in a case where the first dielectric layer 2 is a resin plate, its thickness is for example from 0.1 mm to 10 mm, preferably from 2.0 mm to 5.0 mm, more preferably from 2.0 mm to 4.0 mm.

In a case where the first dielectric layer 2 is a glass plate, the average coefficient of linear thermal expansion at from 50°C to 350°C is for example 120×10⁻⁷/°C or less, preferably 100×10⁻⁷/°C or less, more preferably 90×10⁻⁷/°C or less, whereby warpage and breakage due to a temperature change can be suppressed. The average coefficient of linear thermal expansion is measured in accordance with Japanese Industrial Standards JIS R3102:1995 by a differential thermal dilatometer. The average coefficient of linear thermal expansion of the glass plate may be for example 30×10⁻⁷/°C or more, may be 50×10⁻⁷/°C or more, and may be 70×10⁻⁷/°C or more.

The description of the second dielectric layer 3, which is constituted in the same manner as the first dielectric layer 2, is omitted. However, the combination of the materials of the first dielectric layer 2 and the second dielectric layer 3 is not particularly limited. The first dielectric layer 2 and the second dielectric layer 3 may be formed of the same material or may be formed of different materials. The materials of the first dielectric layer 2 and the second dielectric layer 3 are, as described above, glass, a ceramic or a resin.

The metal woven wire mesh 5 is produced preferably by a loom. The metal woven wire mesh 5 is, as shown in Fig. 2, woven from metal wires 51 lengthwise and crosswise. The metal woven wire mesh 5 has a plurality of metal wires 51 intersecting with one another. The metal wires 51 are disposed to constitute net portions, and apertures 52 are formed to constitute mesh portions. The shape of the apertures 52 may, for example, be rectangular. The rectangular includes a square. The shape of the openings 52 is not limited to rectangular, and may be polygonal such as triangular, rhomboidal, trapezoidal, or pentagonal or more. To the apertures 52, the resin of the resin layer 4 enters at the time of lamination.

The open area ratio of the metal woven wire mesh 5 may, for example, be from 50% to 90%. When the open area ratio is 50% or more, while shielding performance of the electromagnetic wave shielding body 1 is maintained, high visible light transmittance, favorable visibility and good bubble release properties of the resin layer 4 at the time of lamination will be obtained. The open area ratio is preferably 60% or more, more preferably 70% or more, further preferably 75% or more. On the other hand, when the open area ratio is 90% or less, the electromagnetic wave shielding body 1 has a high electromagnetic wave shielding ratio. The open area ratio is preferably 80% or less. The open area ratio is measured as viewed in a plan view.

The material of the metal wires 51 constituting the metal woven wire mesh 5 may be a single metal or an alloy. The material of the metal wires 51 may, for example, be iron, copper, brass, stainless steel (SUS steel), aluminum, nickel, tungsten or nichrome. The metal wires 51 may be strands of a plurality of metal fibers.

The wire diameter of the metal wires 51 is, for example, from 10 µm to 200 µm. When the wire diameter of the metal wires 51 is 10 µm or more, breakage such as breaking of wire is less likely to occur, and good handling efficiency will be achieved. The wire diameter of the metal wires 51 is preferably 20 µm or more. On the other hand, when the wire diameter of the metal wires 51 is 200 µm or less, the metal wires 51 will not be visually noticeable, and good see-through property will be achieved. The wire diameter of the metal wires 51 is preferably 100 µm or less, more preferably 60 µm or less.

The pitches P1 and P2 of the metal wires 51 are respectively, for example, from 50 µm to 1,000 µm. When the pitches P1 and P2 are respectively 50 µm or more, the electromagnetic wave shielding body 1 has a high visible light transmittance and has good see-through property, and bubble release properties of the resin layer 4 are good at the time of lamination. The pitches P1 and P2 are respectively preferably 100 µm or more, more preferably 150 µm or more. On the other hand, when the pitches P1 and P2 are respectively 1,000 µm or less, the electromagnetic wave shielding body 1 has a high electromagnetic wave shielding ratio. The pitches P1 and P2 are respectively preferably 500 µm or less, more preferably 250 µm or less.

The metal woven wire mesh 5 may be an electrical heating element, or may be connected to an electrode to generate heat. By the electrode supplying electricity to the metal woven wire mesh 5, Joule heat will be generated. The generated heat removes moisture condensation on the surface of the electromagnetic wave shielding body 1.

By the way, the metal woven wire mesh 5 according to the present embodiment is produced preferably by a loom, whereby it can be produced at a low cost without by photolithography and etching or by punching, unlike the metal mesh sheet in Patent Document 1. Thus, the metal woven wire mesh 5 can lower the production cost for the electromagnetic wave shielding body 1, as compared with a metal mesh sheet.

However, the metal woven wire mesh 5 according to the present embodiment has e.g. steps at intersections where a plurality of metal wires intersect with one another, unlike the metal mesh sheet in Patent Document 1. The height of the steps is from about two times to about three times the wire diameter of the metal wires 51, and thus it is, for example, from 100 µm to 3,000 µm, preferably from 200 µm to 1,500 µm, more preferably from 300 µm to 750 µm. The steps may deteriorate bubble release properties of the resin layer 4 at the time of lamination. Thus, in order to improve bubble release properties of the resin layer 4 at the time of lamination, use of the silicone resin in Patent Document 2 as the resin for the resin layer 4 may be considered.

However, a silicone resin has high flowability even at room temperature and may flow out from between the first dielectric layer 2 and the second dielectric layer 3 when sandwiched, thus impairing workability. Further, a silicone resin has high water absorption, and a change of appearance is likely to occur after lamination. The change of appearance may occur also by heat cycles.

In this specification, "change of appearance" includes bubbles, discoloration (for example cloudiness) and peeling. The change of appearance may occur at the interface between the resin layer 4 and the metal woven wire mesh 5, at the interface between the resin layer 4 and the first dielectric layer 2, or at the interface between the resin layer 4 and the second dielectric layer 3.

The problem of the change of appearance due to high water absorption may occur also in e.g. a polyvinyl butyral (PVB) resin. Further, the PVB resin is problematic also in that it has low flowability at 100°C and bubble release properties are poor at the time of lamination.

Thus, the resin layer 4 according to the present embodiment contains a thermoplastic ethylene/vinyl acetate (EVA) resin, or a thermoplastic resin containing a block copolymer hydride having some of unsaturated bonds of a block copolymer hydrogenated, and has an elastic modulus in tension E' at 100°C of less than 5.0×10⁵ Pa.

When the elastic modulus in tension E' is less than 5.0×10⁵ Pa, the resin of the resin layer 4 is flexible even at a low laminating temperature of about 100°C, and thus bubble release properties are good. Thus, a reduction in the laminating temperature and improvement of bubble release properties of the resin layer 4 can be realized.

The elastic modulus in tension E' is preferably 4.0×10⁵ Pa or less, more preferably 2.0×10⁵ Pa or less. Further, the elastic modulus in tension E' is preferably 1.0×10⁴ Pa or more.

And, when the resin layer 4 contains the thermoplastic EVA resin or the thermoplastic resin containing the block copolymer hydride, does not substantially flow at room temperature. Thus, when the resin layer 4 is sandwiched between the first dielectric layer 2 and the second dielectric layer 3, it will not flow out, thus leading to good workability. Thus, improvement of workability in laminating operation can be realized.

Further, the EVA resin, and the resin containing the block copolymer hydride, have low water absorption and their change of appearance after lamination is small, as compared with a silicone resin and a PVB resin. Thus, the change of appearance after lamination can be suppressed. The EVA resin, and the resin containing the block copolymer hydride, have a low elastic modulus in tension at 100°C and have good bubble release properties, as compared with a PVB resin.

The resin layer 4 preferably contains the resin containing the block copolymer hydride. The resin containing the block copolymer hydride has low water absorption, and its change of appearance after lamination is smaller, as compared with the EVA resin. Further, the resin containing the block copolymer hydride has good adhesion to the metal wires 51 as compared with the EVA resin. Thus, the change of appearance after lamination can be more suppressed.

The resin containing the block copolymer hydride is, for example, a thermoplastic resin containing a block copolymer hydride having some of unsaturated bonds of a block copolymer hydrogenated, and may, for example, be a cycloolefin polymer (COP). 90% or more of all unsaturated bonds contained in the block copolymer may be hydrogenated.

The block copolymer contains a first component and a second component. The first component is a polymer block containing as the main component repeating units derived from an aromatic vinyl compound. The second component is a polymer block containing as the main component repeating units derived from a chain conjugated diene compound. The ratio (WA:WB) of the weight WA of the first component to the weight WB of the second component is from 30:70 to 60:40.

The elastic modulus in tension at 100°C of the resin containing the block copolymer hydride is determined e.g. by the mixing ratio of the first component and the second component in the block copolymer. The lower the ratio of the second component is, the lower the softening point of the resin containing the block copolymer hydride tends to be, and the lower the elastic modulus in tension at 100°C of the resin containing the block copolymer hydride tends to be. WA:WB is preferably 35:65 to 55:45, more preferably 40:60 to 50:50.

The resin containing the block copolymer hydride may contain, in addition to the block copolymer hydride, an additive. The additive is a conjugated polymer with good compatibility with the block copolymer hydride. By such an additive, the elastic modulus in tension at 100°C can be controlled.

The conjugated polymer with good compatibility may, for example, be a block copolymer hydride which is a precursor of the block copolymer hydride; an olefin polymer such as polyethylene, polypropylene, an ethylene/propylene copolymer or a propylene/ethylene/1-butene copolymer; an isobutylene polymer such as polyisobutylene or an isobutylene/isoprene copolymer hydride; or a petroleum resin or a hydride thereof, such as a 1,3-pentadiene petroleum resin, a cyclopentadiene petroleum resin or a styrene/indene petroleum resin.

The resin layer 4 may contain the thermoplastic EVA resin. The thermoplastic EVA resin contains no organic peroxide nor silane coupling agent and has no heat cross-linking property. That is, the thermoplastic EVA resin has contents of an organic peroxide and a silane coupling agent of 0 mass%. If an organic peroxide or a silane coupling agent is mixed with the EVA resin, heat cross-linking property may be imparted to make the resin a curable resin. Further, if the EVA resin contains an organic peroxide or a silane coupling agent, the EVA resin is crosslinked and cured by heat-pressurization treatment in an autoclave, and the elastic modulus in tension of the EVA resin increases as the curing by crosslinking progresses, bubbles are likely to remain between the metal woven wire mesh and the EVA resin, and thus transparency and reliability may be impaired. Whereas an organic peroxide or a silane coupling agent is mixed with the resin containing the block copolymer hydride, the resin will not become a curable resin.

The EVA resin contains, for example, per 100 parts by weight of the EVA resin having a vinyl acetate content of from 15 wt% to 50 wt% and having a melt mass flow rate measured in accordance with JIS K6924-1 of from 0.1 g/10 min to 100 g/10 min, from 0.5 to 10 parts by weight of a low molecular weight compound having a refractive index of from 1.480 to 1.600 and having solubility parameter measured by Fedors method of from 8.5 to 10.1. The EVA resin has a vinyl acetate content of from 15 wt% to 50 wt%, preferably within a range of from 20 wt% to 35 wt%, whereby low temperature adhesion to an adherend and transparency will be more excellent. When the vinyl acetate content is 15 wt% or more, the obtainable adhesive resin composition and its formed product will be excellent in low temperature adhesion. On the other hand, when the vinyl acetate content is 50 wt% or less, adhesion at ordinary temperature tends to be weak, and the softening temperature tends to be high, whereby the obtainable resin composition and its formed product will be excellent in blocking resistance. The vinyl acetate content of the EVA resin may be obtained, for example, by the vinyl acetate content measured in accordance with JIS K6924-1. The melt mass flow rate (MFR) of the EVA resin is preferably within a range of from 0.01 g/10 min to 100 g/10 min as measured in accordance with JIS K6924-1 at a temperature of 190°C under a load of 21.18 N, and in order to achieve more excellent extrusion property, more preferably from 0.5 g/10 min to 40 g/10 min. When the melt mass flow rate is 0.01 g/10 min or more, extrusion load and the resin pressure at the time of forming tend to be low, thus leading to excellent processability, and when it is 100 g/10 min or less, draw down at the time of melting tends to be small, thus leading to excellent handling efficiency and shaping property at the time of compounding.

The low molecular weight compound is incorporated mainly for the purpose of improving transparency. The low molecular weight compound is a compound having a molecular weight of several thousands or less, having a specific refractive index and specific solubility parameter, specifically, may, for example, be a phthalate, a trimellitate, a phosphate, a benzoate or a sebacate, such as dibutyl phthalate, tris-2-ethylhexyl trimellitate, tricresyl phosphate, triphenyl phosphate, diphenylmethane or benzyl benzoate. By mixing such a low molecular weight compound having a specific refractive index and specific solubility parameter with the EVA resin, the crystallinity of the EVA resin will be lowered, and the transparency will improve.

The EVA resin may further contain a hydrogenated hydrocarbon resin. The hydrogenated hydrocarbon resin is incorporated for the purpose of improving transparency and tack property. Specifically, it may be an aliphatic hydrocarbon resin, an alicyclic hydrocarbon resin or an aromatic hydrocarbon resin. The aliphatic hydrocarbon resin may, for example, be a polymer composed mainly of a C4 to C5 mono- or diolefin such as 1-butene, butadiene, isobutylene or 1,3-pentadiene, the alicyclic hydrocarbon resin may be a resin having diene components in spent C4 to C5 fractions cyclodimerized and then polymerized or a resin having a cyclic monomer such as cyclopentadiene polymerized, and the aromatic hydrocarbon resin may, for example, be a resin containing as a component a C2 vinyl aromatic hydrocarbon resin such as vinyl toluene, indene or α- methyltoluene. Among such hydrocarbon resins, in view of compatibility with the ethylene/vinyl acetate copolymer and the hue, a partially hydrogenated petroleum hydrocarbon resin having a low softening temperature is more preferred. The amount of the hydrogenated hydrocarbon resin incorporated to the EVA resin is within a range of from 5 parts by weight to 30 parts by weight, and more preferably within a range of from 10 parts by weight to 20 parts by weight, whereby a resin composition that gives a formed product having more excellent handling efficiency at ordinary temperature, in addition to transparency and tack property, will be obtained.

Or, the resin layer 4 according to the present embodiment has a coefficient of water absorption measured in accordance with ASTM D570 (Standard test method for water absorption of plastics) of less than 0.1%, has an elastic modulus in tension at 25°C of 10 kPa or more, and has an elastic modulus in tension E' at 100°C of less than 5.0×10⁵ Pa.

When the elastic modulus in tension E' is less than 5.0×10⁵ Pa, the resin of the resin layer 4 is flexible even at a low laminating temperature of about 100°C, and thus bubble release properties will be good. Thus, a reduction in the laminating temperature and improvement of bubble release properties of the resin layer 4 can be realized.

The elastic modulus in tension E' is preferably 4.0×10⁵ Pa or less, more preferably 2.0×10⁵ Pa or less. The elastic modulus in tension E' is preferably 1.0×10⁴ Pa or more.

The resin layer 4 does not substantially flow at room temperature when it has an elastic modulus in tension at 25°C of 10 kPa or more. Thus, when the resin layer 4 is sandwiched between the first dielectric layer 2 and the second dielectric layer 3, it will not flow out, thus leading to good workability. Thus, improvement of workability in laminating operation can be realized. The elastic modulus in tension at 25°C is preferably 30 kPa or more, more preferably 50 kPa or less.

When the resin layer 4 has a coefficient of water absorption of less than 0.1% measured in accordance with ASTM D570 (Standard test method for water absorption of plastics) of less than 0.1%, its water absorption is low and its change of appearance after lamination can be suppressed. The coefficient of water absorption is preferably 0.05% or less, more preferably 0.03% or less.

As the resin layer 4, a resin containing a thermoplastic polyurethane (TPU) may, for example, be mentioned. The thermoplastic polyurethane is obtained, for example, by copolymerization of a polyisocyanate, a high molecular weight polyol and a chain elongation agent. The elastic modulus in tension of the thermoplastic polyurethane (TPU) changes by the molecular weight between cross-linkages, which is a molecular weight between the bonding functional group of the polyisocyanate and the bonding functional group of the high molecular weight polyol. Specifically, the coefficient of elasticity tends to be low as the molecular weight between cross-linkages increases, and the coefficient of elasticity tends to be high as the molecular weight between cross-linkages decreases.

The polyisocyanate may, for example, be an aliphatic, alicyclic or aromatic diisocyanate, whereby the coefficient of water absorption can be made low, and is preferably an aromatic diisocyanate. More specifically, it may, for example, be an aliphatic diisocyanate such as hexamethylene diisocyanate or 2,2,4-trimethylhexamethylene diisocyanate; an alicyclic diisocyanate such as 1,4-cyclohexane diisocyanate, isophorone diisocyanate or 4,4'-dicyclohexylmethane diisocyanate; or an aromatic diisocyanate such as p-phenylene diisocyanate, 2,4-toluene diisocyanate, 2,6-toluene diisocyanate, 3,3'-dimethyldiphenyl-4,4'- diisocyanate or 4,4'-diphenylmethane diisocyanate. Among them, 4,4'-diphenylmethane diisocyanate is preferred.

The high molecular weight polyol is preferably a polyether polyol or polyester polyol, having a molecular weight of from 500 to 8,000, more preferably from about 600 to about 4,000.

The polyether polyol may, for example, be polyoxyethylene glycol, polyoxypropylene glycol, polyoxyethylene oxypropylene glycol, polyoxytetramethylene glycol or polyoxyhexamethylene glycol. Among them, polyoxytetramethylene glycol is preferred.

The polyester polyol is preferably an aliphatic polyester polyol derived from an aliphatic dicarboxylic acid and an aliphatic diol, whereby the coefficient of water absorption can be made low. More specifically, it may, for example, be polyethylene adipate, polytetramethylene adipate, polyhexamethylene adipate, polytetramethylene sebacate, poly(diethylene glycol adipate), poly(hexamethylene glycol-1,6-carbonate) or polycaprolactone, the both terminals of which are diol components.

The chain elongation agent may, for example, be a diol having a molecular weight of preferably 400 or less, more preferably 300 or less. Specifically, it may, for example, be ethylene glycol, 1,2-propanediol, 1,3-propanediol, 1,4-butanediol, 1,6-hexanediol, diethylene glycol, triethylene glycol, bisphenol A or p-xylylene glycol.

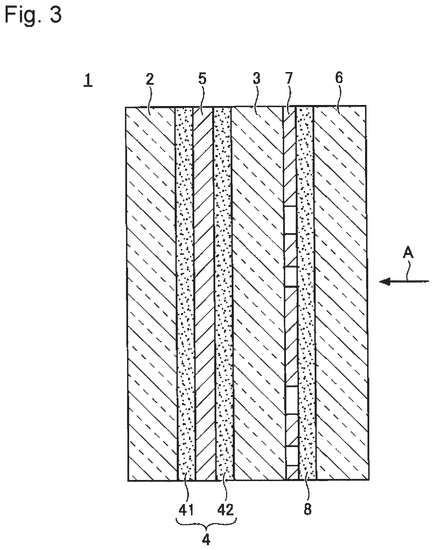

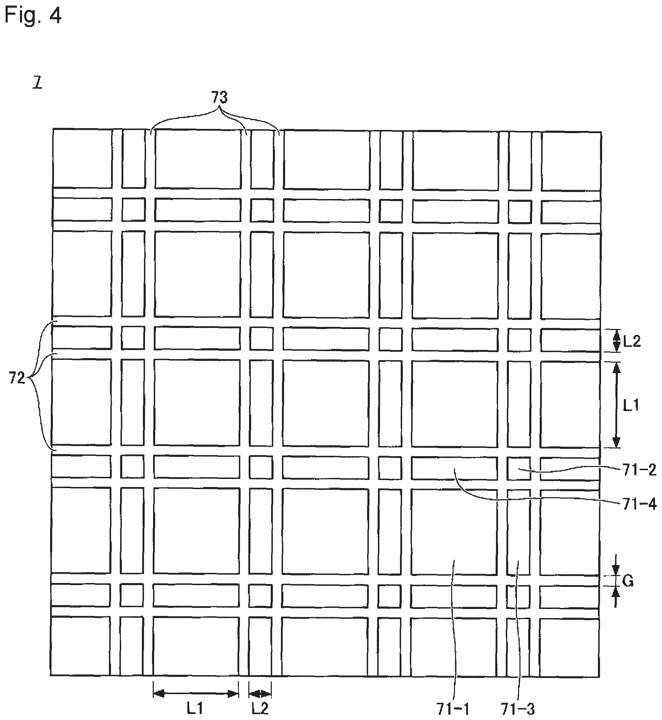

Now, an electromagnetic wave shielding body 1 according to a first modified example will be described with reference to Figs. 3 and 4. The electromagnetic wave shielding body 1 according to the present modified example has, in the same manner as the electromagnetic wave shielding body 1 of the above embodiment, a first dielectric layer 2, a second dielectric layer 3, and a resin layer 4 to bond the first dielectric layer 2 and the second dielectric layer 3. Further, the electromagnetic wave shielding body 1 further has a metal woven wire mesh 5 disposed in the resin layer 4. The resin layer 4 contains, for example, a first adhesive layer 41 and a second adhesive layer 42. The metal woven wire mesh 5 is disposed between the first adhesive layer 41 and the second adhesive layer 42.

The electromagnetic wave shielding body 1 according to the present modified example has, unlike the electromagnetic wave shielding body 1 of the above embodiment, a third dielectric layer 6 disposed on the opposite side of the second dielectric layer 3 from the first dielectric layer 2, and a conductive layer 7 disposed between the second dielectric layer 3 and the third dielectric layer 6.

As shown in Fig. 4, the conductive layer 7 has a plurality of conductors 71-1 to 71-4 separated from one another by gaps and insulated from one another. The conductive layer 7 is preferably a transparent conductive film formed of e.g. ITO (indium tin oxide). The conductive layer 7 may be a so-called FSS (Frequency Selective Shield).

The conductive layer 7 reflects a part of electromagnetic waves propagating in the direction of the arrow A in Fig. 3, absorbs another part, and transmits the other part. The electromagnetic waves which had transmitted through the conductive layer 7 are reflected on the metal woven wire mesh 5. The electromagnetic waves reflected on the conductive layer 7 and the electromagnetic waves reflected on the metal woven wire mesh 5 interfere with each other and are cancelled out each other. As a result, the electromagnetic waves are absorbed.

When the electromagnetic waves arrive at the conductive layer 7, free electrons in the conductors 71-1 to 71-4 move in the direction opposite to the direction of the electric field of the electromagnetic waves, and an electric current flows in the conductors 71-1 to 71-4. Further, on that occasion, at the gaps between the conductors 71-1 to 71-4, energy is periodically accumulated by the electric field generated and discharged. As a result, propagation delay of electromagnetic waves transmitting through the conductive layer 7 occurs. That is, there is a delay time from when the electromagnetic waves enter the conductive layer 7 until when they are re-radiated. Thus, the distance between the conductive layer 7 and the metal woven wire mesh 5 can be made shorter than λ/4 and the electromagnetic wave shielding body 1 can be made thin.

As shown in Fig. 4, the conductive layer 7 has a plurality of first slits 72 and a plurality of second slits 73 orthogonal to each other, as gaps separating the plurality of conductors 71-1 to 71-4. The plurality of first slits 72 and the plurality of second slits 73 form quadrangular lattices, and the conductors 71-1 to 71-4 are formed rectangular as viewed in a plan view. The rectangular includes square.

The distances between adjacent first slits 72 are set alternately to first distances L1 and second distances L2 narrower than the first distances L1. Likewise, the distances between adjacent second slits 73 are also set alternately to first distances L1 and second distances L2. As a result, four types of conductors 71-1, 71-2, 71-3 and 71-4 are formed as viewed in a plan view.

The conductor 71-1 is a square with lengths of the four sides being L1. The conductor 71-2 is a square with lengths of the four sides being L2. The other two conductors 71-3 and 71-4 have lengths of facing two sides being L1 and lengths of the other two sides being L2.

The average of the lengths of the outer peripheries of the four types of conductors 71-1 to 71-4 is represented by the formula 2×(L1+L2). The average of the lengths of the outer peripheries is for example from 60 mm to 180 mm, preferably from 80 mm to 150 mm.

L1 and L2 are different in the present modified example but may be the same. In such a case also, the average of the lengths of the outer peripheries is represented by the formula 2×(L1+L2).

The line width G of each of the first slits 72 and the second slits 73 is preferably, for example, from 30 µm to 150 µm. When G is 30 µm or more, processing will be easy. Further, when G is 150 µm or less, the electric filed generated between the conductors 71-1 to 71-4 tends to be large, and the delay time tends to be long. The line width of the first slits 72 and the line width of the second slits 73 are the same in the present embodiment, however, they may be different from each other.

As shown in Fig. 3, the conductive layer 7 is formed preferably on the surface facing the third dielectric layer 6 of the second dielectric layer 3. For example, on the surface facing the third dielectric layer 6, a transparent conductive film may be formed e.g. by deposition or by sputtering, and the formed transparent conductive film is patterned e.g. by laser processing. The conductive layer 7 may be formed by printing using a conductive ink. The conductive layer 7 is bonded to the third dielectric layer 6 via the third adhesive layer 8.

In the present modified example, the conductive layer 7 is formed on the surface facing the third dielectric layer 6 of the second dielectric layer 3, and the third adhesive layer 8 is disposed between the conductive layer 7 and the third dielectric layer 6, however, the technique disclosed in the present disclosure is not limited thereto. For example, the conductive layer 7 may be formed on the surface facing the second dielectric layer 3 of the third dielectric layer 6, and the third adhesive layer 8 may be disposed between the conductive layer 7 and the second dielectric layer 3. Further, the conductive layer 7 may be formed on an insulating substrate which is not shown, and the third adhesive layer 8 may be disposed between the conductive layer 7 and the second dielectric layer 3 and between the conductive layer 7 and the third dielectric layer 6.

The third dielectric layer 6 protects the conductive layer 7. The third dielectric layer 6 is formed of e.g. glass, a ceramic or a resin, in the same manner as the first dielectric layer 2 and the second dielectric layer 3. From the viewpoint of weight saving, the material of the third dielectric layer 6 is preferably a resin. As specific examples of the resin, a PET resin, a PC resin and an acrylic resin may be mentioned. Further, from the viewpoint of scratch resistance, the material of the third dielectric layer 6 is preferably glass or a ceramic.

In a case where the third dielectric layer 6 is a glass plate or a ceramic plate, its thickness is for example from 1.8 mm to 4.0 mm, preferably from 1.8 mm to 3.0 mm. On the other hand, in a case where the third dielectric layer 6 is a resin plate, its thickness is for example from 2.0 mm to 5.0 mm, preferably from 2.0 mm to 4.0 mm.

In a case where the third dielectric layer 6 is a glass plate, the tanδ (also called dielectric loss tangent) of the glass plate is preferably 0.025 or less, more preferably 0.020 or less, further preferably 0.010 or less. tanδ of the glass plate is preferably 0.0001 or more. Further, the relative dielectric constant of the glass plate is preferably 8 or less, more preferably 6 or less. The relative dielectric constant of the glass plate is preferably 3.5 or more.

In a case where the third dielectric layer 6 is a resin plate, tanδ of the resin plate is preferably 0.2 or less, more preferably 0.1 or less. tanδ of the resin plate is preferably 0.0005 or more. Further, the relative dielectric constant of the resin plate is preferably 5 or less, more preferably 4 or less. The relative dielectric constant of the resin plate is preferably 2 or more.

tanδ is a value represented by ε2/ε1 employing the complex dielectric constant, and ε1 is the relative dielectric constant, and ε2 is the dissipation loss. The smaller tanδ is, the smaller the absorption of radio waves in the frequency band is. tanδ and the relative dielectric constant are values measured in accordance with the method specified in IEC (International Electrotechnical Commission) 61189-2-721 (2015), at a measurement frequency of 1 GHz.

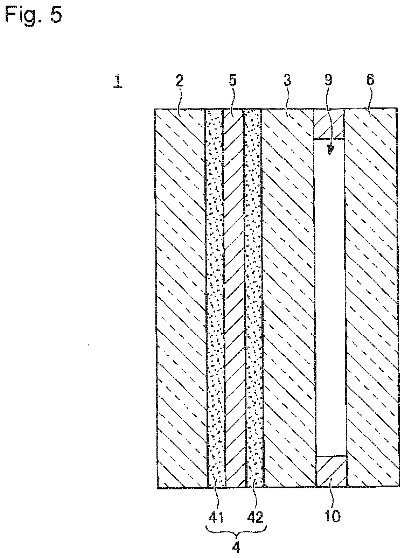

Now, the electromagnetic wave shielding body 1 according to a second modified example will be described with reference to Fig. 5. The electromagnetic wave shielding body 1 of the present modified example also has, in the same manner as the electromagnetic wave shielding body 1 of the above embodiment, a first dielectric layer 2, a second dielectric layer 3, and a resin layer 4 to bond the first dielectric layer 2 and the second dielectric layer 3. Further, the electromagnetic wave shielding body 1 further has a metal woven wire mesh 5 disposed in the resin layer 4. The resin layer 4 contains, for example, a first adhesive layer 41 and a second adhesive layer 42. The metal woven wire mesh 5 is disposed between the first adhesive layer 41 and the second adhesive layer 42.

The electromagnetic wave shielding body 1 of the present modified example has, unlike the electromagnetic wave shielding body 1 of the above embodiment, a third dielectric layer 6 formed on the opposite side of the second dielectric layer 3 from the first dielectric layer 2, and an air layer 9 disposed between the second dielectric layer 3 and the third dielectric layer 6. The air layer 9 is surrounded by a spacer 10. The air layer 9 secures heat insulating property.

The third dielectric layer 6 is formed of, in the same manner as the first dielectric layer 2 and the second dielectric layer 3, glass, a ceramic or a resin. From the viewpoint of weight saving, the material of the third dielectric layer 6 is preferably a resin. As specific examples of the resin, a PET resin, a PC resin or an acrylic resin may be mentioned. On the other hand, from the viewpoint of scratch resistance, the material of the third dielectric layer 6 is preferably glass or a ceramic.

In a case where the third dielectric layer 6 is a glass plate or a ceramic plate, its thickness is for example from 1.8 mm to 4.0 mm, preferably from 1.8 mm to 3.0 mm. On the other hand, in a case where the third dielectric layer 6 is a resin plate, its thickness is for example from 2.0 mm to 5.0 mm, preferably from 2.0 mm to 4.0 mm.

On the surfaces of the third dielectric layer 6 and the second dielectric layer 3, facing each other, a Low-E film (low emissivity film) which is not shown, may be formed. As the Low-E film, one containing a tin oxide layer or an indium oxide layer, and one containing a silver (Ag) layer are present.

The Low-E film containing a tin oxide layer or an indium oxide layer is advantageous in that it is less deteriorated by heat, however, it originally has high emissivity (vertical emissivity εn of about 0.15 or more), and improvement of heat insulating property and heat shielding property can hardly be expected, and heat shielding property at the time of fire cannot be expected. That is, remarkable improvement of fire proof performance cannot be expected.

On the other hand, the Low-E film containing a silver layer has a low emissivity (vertical emissivity εn of about 0.1 or less) and has excellent heat insulating property and heat shielding property, and it can effectively prevent breakage of the glass plate if its emissivity is maintained at the time of fire.

Accordingly, as the Low-E film to be used as a heat resistant Low-E film, a Low-E film containing a silver layer is preferably used. Since silver is easily oxidized when heated and its performance is likely to be deteriorated, a structure that withstands heat, that is a structure such that silver is less likely to be deteriorated by heat, is preferred. For example, the following structures (A) and (B) may be mentioned.
(A) A Low-E film having an oxide dielectric layer, a barrier layer, a silver layer, a barrier layer and an oxide dielectric layer in this order, directly formed on a glass substrate in this order. Each barrier layer is formed of a metal, and the thickness of each barrier layer is 2 nm or more. By the barrier layer being present between the silver layer and the oxide dielectric layer, oxidation of silver can be suppressed, and deterioration of heat reflecting performance can be suppressed. Further, when each barrier layer is formed of a metal and the thickness of each barrier layer is 2 nm or more, heat resistance will be favorable. The metal constituting the barrier layer may, for example, be zinc alloy (Zn alloy) or titanium (Ti).

In a case where a metal barrier layer is provided for a conventional Low-E film, the thickness of the Zn alloy barrier layer is about 0.7 nm, and the thickness of the Ti barrier layer is about 1.5 nm.

The thicker the barrier layer in (A), the more favorable the heat resistance, however, the transmittance tends to lower. The thickness of the barrier layer in (A) is determined considering the heat resistance and transmission.

(B) A Low-E film having a non-oxide dielectric layer, a barrier layer, a silver layer, a barrier layer and a non-oxide dielectric layer in this order, directly formed on a glass plate in this order. By a structure such that a silver layer is sandwiched between non-oxide dielectric layers, oxidation of silver in high temperature environment can be suppressed, and while high heat reflecting performance is secured, high heat resistance can be secured.

The barrier layer in (B) is, in the same manner as the barrier layer in (A), formed of a Zn alloy, Ti or the like, whereby heat resistance can further be improved. The barrier layer in (B) may be formed of the same material as the non-oxide dielectric layer.

The Low-E film may contain a plurality of silver layers. By forming a plurality of silver layers, the emissivity can further be lowered, and εn can be made much lower than 0.1. For example, the Low-E film has an oxide dielectric layer, a barrier layer, a silver layer, a barrier layer, an oxide dielectric layer, a barrier layer, a silver layer, a barrier layer and an oxide dielectric layer in this order directly formed on a glass plate in this order.

### EXAMPLES

Now, experimental data will be described. Ex. 1 to 2, 4 and 6 to 7 are Comparative Examples, and Ex. 3 and 5 are Examples of the present invention.

### [Ex. 1]

In Ex. 1, a first dielectric layer, a first adhesive layer, a metal woven wire mesh, a second adhesive layer and a second dielectric layer were laminated in this order to prepare a laminate. As the first dielectric layer and the second dielectric layer, a soda lime glass plate of 600 mm × 600 mm × 2.7 mm in thickness was prepared. As the metal woven wire mesh, a fiber sheet (manufactured by ASADA MESH CO., LTD., model: 0500A00-00) formed of stainless steel wires having a wire diameter of 50 µm was prepared. As the first adhesive layer and the second adhesive layer, TPU resin sheet (manufactured by HUNTSMAN, model: PE399) was prepared.

Then, the laminate was put in a vacuum bag, and in a state where the vacuum bag was evacuated of air, the vacuum bag was baked in the air. The baking temperature was 85°C. Then, the laminate was taken out from the vacuum bag and heated while pressurized in an autoclave. The heating temperature was 100°C. As a result, the first adhesive layer and the second adhesive layer entered into apertures of the metal woven wire mesh and integrated to form an electromagnetic wave shielding body.

### [Ex. 2]

In Ex. 2, an electromagnetic wave shielding body was prepared in the same manner as in Ex. 1 except that as the first adhesive layer and the second adhesive layer, a PVB resin sheet (manufactured by SEKISUI CHEMICAL CO., LTD., model: RZRX) was prepared.

### [Ex. 3]

In Ex. 3, an electromagnetic wave shielding body was prepared in the same manner as in Ex. 1 except that as the first adhesive layer and the second adhesive layer, a thermoplastic EVA resin sheet (manufactured by TOSOH NIKKEMI CORPORATION, model: G7055) containing no organic peroxide nor silane coupling agent was prepared.

### [Ex. 4]

In Ex. 4, an electromagnetic wave shielding body was prepared in the same manner as in Ex. 1 except that as the first adhesive layer and the second adhesive layer, a thermosetting EVA resin sheet (manufactured by Bridgestone Corporation, model: EVASAFE) containing 0.04 mass% of an organic peroxide and containing no silane coupling agent was prepared.

### [Ex. 5]

In Ex. 5, an electromagnetic wave shielding body was prepared in the same manner as in Ex. 1 except that as the first adhesive layer and the second adhesive layer, a thermoplastic resin sheet (manufactured by Zeon Corporation, model: LS-XT) containing a block copolymer hydride was prepared.

### [Ex. 6]

In Ex. 6, an electromagnetic wave shielding body was prepared in the same manner as in Ex. 1 except that as the first adhesive layer and the second adhesive layer, a thermoplastic resin sheet (manufactured by Zeon Corporation, model: LS) containing a block copolymer hydride was prepared.

### [Ex. 7]

In Ex. 7, the same two glass plates and metal woven wire mesh as in Ex. 1 were prepared, and an electromagnetic wave shielding body was prepared in the method described in Patent Document 2. Specifically, on one of the glass plates, the metal woven wire mesh was disposed, the metal woven wire mesh was coated with a silicone resin (manufactured by MOMENTIVE, model: SN3001), the other glass plate was further disposed, and the silicone resin was heat-cured.

### [Evaluation]

### <Elastic modulus in tension E' at 100°C of resin>

The elastic modulus in tension E' at 100°C of the resin is a storage elastic modulus in tension, and was determined from a stress-strain curve obtained by a tensile test carried out in accordance with JIS K7244-4:1999. The test specimen in the tensile test had a width of 5 mm and a length of 20 mm. As the tensile tester, itk DVA-200 was used. The rate of pulling was 500 mm/min, the measurement frequency was 1 Hz, and the temperature-increasing rate and the temperature-decreasing rate were 2°C/min.

### <Coefficient of water absorption of resin>

The coefficient of water absorption of the resin was measured in accordance with ASTM D570 (Standard test method for water absorption of plastics).

### <Bubbles at the time of lamination>

Whether bubbles were present at the time of lamination or not was examined by observing intersections of a plurality of metal wires constituting the metal woven wire mesh, immediately after preparation of the electromagnetic wave shielding body.

### <Heat and moisture resistance test>

The heat and moisture resistance test of the electromagnetic wave shielding body was carried out by using a constant temperature and humidity chamber. The treatment in the constant temperature and humidity chamber was carried out at a temperature of 60°C under a humidity of 95% for 1,000 hours. The electromagnetic wave shielding body, after treated in the constant temperature and humidity chamber, was left to stand in the air for one day, and then a change of appearance was observed.

### <Heat cycle test>

The heat cycle test of the electromagnetic wave shielding body was also carried out by using a constant temperature and humidity chamber. A cycle of keeping the temperature of the constant temperature and humidity chamber at -20°C for 1 hour, increasing it from -20°C to 50°C in 2 hours, keeping it at 50°C for one hour and decreasing it from 50°C to -20°C in 2 hours, was repeatedly carried out 48 times. The electromagnetic wave shielding body, after treated in the constant temperature and humidity chamber, was left to stand in the air for one day, and then a change of appearance was observed.

### <Summary>

The evaluation results are summarized in Table 1.

**[Table 1]**

| | Resin layer | E' (Pa) | Coefficient of water absorption (%) | Bubbles at the time of lamination | Heat and moisture resistance test | | Heat cycle test | |
|---|---|---|---|---|---|---|---|---|
| | | | | | Edge | Interface | Edge | Interface |
| Ex.1 | TPU | 1.5×10⁶ | 0.80 | Observed | × | × | △ | △ |
| Ex.2 | PVB | 8.3×10⁵ | 0.20 | Observed | × | × | × | × |
| Ex. 3 | EVA1 | 9.2×10⁴ | 0.03 | Nil | △ | △ | △ | △ |
| Ex.4 | EVA2 | | | | × | × | × | × |
| Ex. 5 | COP1 | 1.0×10⁵ | <0.01 | Nil | ○ | ○ | ○ | ○ |
| Ex.6 | COP2 | 2.2×10⁷ | <0.01 | Observed | ○ | ○ | ○ | ○ |
| Ex.7 | Silicone | | | Nil | × | × | × | △ |

In Table 1, "×" indicates that the change of appearance was visually recognizable from 3 m distance and that the object of the present invention was not achieved. "△" indicates good results as compared with "×" with a change of appearance invisible from 3 m distance. "○" indicates most excellent results with no change of appearance, and that the object of the present invention can be achieved. In Table 1, "edge" means that the position where the change of appearance was observed was at the outer periphery of the resin layer, and "interface" means that the position where the change of appearance was observed was at the interface between the metal wire and the resin and at the interface between the resin and the glass plate. In Table 1, COP1 and COP2 mean the thermoplastic resin containing the block copolymer hydride.

In Ex. 3 and 5, the resin of the resin layer was the thermoplastic EVA resin, or the thermoplastic resin containing the block copolymer hydride. And, the resin layer had an elastic modulus in tension E' at 100°C of less than 5.0×10⁵ Pa. Thus, a reduction in the laminating temperature, improvement of bubble release properties of the resin layer, improvement of workability in laminating operation, and suppression of the change of appearance after lamination, could be realized.

Whereas in Ex. 1 to 2 and 6, the resin layer had an elastic modulus in tension E' at 100°C of 5.0×10⁵ Pa or more, and thus bubble release properties of the resin layer were poor, and bubbles formed at the time of lamination. Further, in Ex. 1 to 2, the resin of the resin layer was a TPU resin or a PVB resin having a coefficient of water absorption of 0.1% or more, and thus a change of appearance occurred after lamination.

Further, in Ex. 4, the resin of the resin layer was a thermosetting EVA resin, and thus a change of appearance occurred after lamination.

Further, in Ex. 7, the resin of the resin layer was a silicone resin, and thus a change of appearance occurred after lamination. Further, in Ex. 7, since the resin of the resin layer was a silicone resin, the resin layer could not be laminated in a sheetform, thus leading to poor workability.

The electromagnetic wave shielding body according to the present disclosure has been described above. However, it should be understood that the present invention is by no means restricted to the above specific embodiments. Various changes, modification, replacement, addition, deletion and combination are possible without departing from the intension and the scope of the present invention. They of course belong to the technical range of the present disclosure.

The entire disclosure of Japanese Patent Application No. 2020-189668 filed on November 13, 2020 including specification, claims, drawings and summary is incorporated herein by reference in its entirety.

### REFERENCE SYMBOLS

- 1: electromagnetic wave shielding body
- 2: first dielectric layer
- 3: second dielectric layer
- 4: resin layer
- 5: metal woven wire mesh

## Claims

1. An electromagnetic wave shielding body for shielding electromagnetic waves, comprising;
a first dielectric layer,
a second dielectric layer,
a resin layer to bond the first dielectric layer and the second dielectric layer,
and a metal woven wire mesh disposed in the resin layer,
wherein the metal woven wire mesh has apertures formed by metal wires intersecting with one another,
the resin layer contains a thermoplastic ethylene/vinyl acetate (EVA) resin or a thermoplastic resin containing a block copolymer hydride having some of unsaturated bonds of a block copolymer hydrogenated,
the thermoplastic EVA resin contains no organic peroxide nor silane coupling agent, and
the resin layer has an elastic modulus in tension at 100°C of less than 5.0×10⁵ Pa.

2. The electromagnetic wave shielding body according to Claim 1, wherein the resin layer contains the thermoplastic resin containing the block copolymer hydride.

3. The electromagnetic wave shielding body according to Claim 2, wherein the block copolymer contains a polymer block containing repeating units derived from an aromatic vinyl compound as the main component, and a polymer block containing repeating units derived from a chain conjugated diene compound as the main component.

4. The electromagnetic wave shielding body according to Claim 1, wherein the resin layer contains the thermoplastic EVA resin.

5. An electromagnetic wave shielding body for shielding electromagnetic waves, comprising;
a first dielectric layer,
a second dielectric layer,
a resin layer to bond the first dielectric layer and the second dielectric layer,
and a metal woven wire mesh disposed in the resin layer,
wherein the metal woven wire mesh has apertures formed by metal wires intersecting with one another,
the resin layer has a coefficient of water absorption of less than 0.1% measured in accordance with ASTM D570 (Standard test method for water absorption of plastics),
the resin layer has an elastic modulus in tension at 25°C of 10 kPa or more, and
the resin layer has an elastic modulus in tension at 100°C of less than 5.0×10⁵ Pa.

6. The electromagnetic wave shielding body according to any one of Claims 1 to 5, wherein of the metal woven wire mesh, the wire diameter of the metal wires is from 10 µm to 200 µm, and the open area ratio is from 50% to 90%.

7. The electromagnetic wave shielding body according to Claim 6, wherein of the metal woven wire mesh, the pitch of the metal wires is from 50 µm to 1,000 µm.

8. The electromagnetic wave shielding body according to any one of Claims 1 to 7, which has a visible light transmittance of 30% or more.

9. The electromagnetic wave shielding body according to any one of Claims 1 to 8, wherein when the frequency of electromagnetic waves is from 100 MHz to 1 GHz, the electromagnetic wave shielding ratio is 40 dB or more.

10. The electromagnetic wave shielding body according to any one of Claims 1 to 9, wherein at least one of the first dielectric layer and the second dielectric layer is formed of glass.

11. The electromagnetic wave shielding body according to any one of Claims 1 to 10, wherein at least one of the first dielectric layer and the second dielectric layer is formed of a polycarbonate (PC) resin or an acrylic resin.

12. The electromagnetic wave shielding body according to any one of Claims 1 to 11, which has a third dielectric layer disposed on the opposite side of the second dielectric layer from the first dielectric layer, and a conductive layer disposed between the second dielectric layer and the third dielectric layer, and
wherein the conductive layer has a plurality of conductors and gaps disposed to separate the plurality of conductors, and the plurality of conductors are insulated from one another.

13. The electromagnetic wave shielding body according to any one of Claims 1 to 11, which has a third dielectric layer disposed on the opposite side of the second dielectric layer from the first dielectric layer, and an air layer disposed between the second dielectric layer and the third dielectric layer.
